# EUROPÄISCHE PATENTSCHRIFT

(11) **EP 1 963 227 B1**
(45) Veröffentlichungstag und Bekanntmachung des Hinweises auf die Patenterteilung: **28.03.2012**
(21) Anmeldenummer: 06841275.8
(22) Anmeldetag: 29.11.2006
(51) Int. Cl.: B81C 1/00

(54) **MIKROMECHANISCHES BAUELEMENT UND HERSTELLUNGSVERFAHREN**
MICROMECHANICAL COMPONENT AND PRODUCTION METHOD
COMPOSANT MICROMECANIQUE ET PROCEDE DE FABRICATION DUDIT COMPOSANT

(30) Priorität: 15.12.2005 DE 102005059905
(43) Veröffentlichungstag der Anmeldung: 03.09.2008
(73) Patentinhaber: ROBERT BOSCH GMBH, 70442 Stuttgart (DE)
(72) Erfinder: KAELBERER, Arnd, 73278 Schlierbach (DE); FREY, Jens, 70794 Filderstadt (DE)
(86) Internationale Anmeldenummer: PCT/EP2006/069044
(87) Internationale Veröffentlichungsnummer: WO 2007/068590

(56) Entgegenhaltungen:
- EP-A- 1 228 998
- WO-A-01/44822
- US-A- 5 679 436

## Beschreibung

### STAND DER TECHNIK

Die Erfindung geht aus von einem mikromechanischen Bauelement sowie einem Verfahren zur Herstellung dieses Bauelements gemäß dem Oberbegriff der unabhängigen Ansprüche.

Ein Herstellungsverfahren und ein solchermaßen hergestellter mikromechanischer Sensor sind aus der deutschen Offenlegungsschrift DE 19537814 A1 bekannt. Dort wird ein oberflächenmikromechanischer Sensor beschrieben, der über einem Substrat eine erste Isolationsschicht, eine Leitschicht, eine zweite Isolationsschicht und schließlich eine mikromechanische Funktionsschicht aufweist. Die mikromechanische Funktionsschicht weist bewegliche mikromechanische Strukturen auf, die durch Ätzen der Isolationsschichten freigelegt sind. Bei der Herstellung des Sensors kann es zu teilweisen Unterätzungen der Leitschicht kommen. Wenn durch äußere Einwirkungen wie z.B. starke Stöße die beweglichen mikromechanischen Strukturen auf solche unterätzten Bereiche der Leitschicht aufschlagen, kann es zu Abbrüchen an der Leitschicht kommen.

Aufgabe der Erfindung ist die Beseitigung der Gefahr der Partikelbildung beim Aufschlagen der beweglichen mikromechanischen Struktur auf die unterätzten Siliziumleiterbahnen. Dadurch soll eine Erhöhung der Robustheit des Sensorelements gegenüber hohen Beschleunigungen erreicht werden.

Die Druckschrift EP 12228998 zeigt einen weiteren kapazitiven Beschleunigungssensor im Stand der Technik, der über einem Substrat eine erste Isolationsschicht, eine Leitschicht, eine zweite Isolationsschicht und schließlich eine mikromechanische Funktionsschicht aufweist. Die mikromechanische Funktionsschicht weist bewegliche mikromechanische Strukturen auf, die durch Ätzen der Isolationsschichten freigelegt sind. Bei der Herstellung des Sensors wird die Leitschicht teilweise unterätzt. Die beweglichen mikromechanischen Strukturen können sowohl auf unterätzte als auch auf nicht unterätzte Bereiche der Leitschicht aufschlagen.

Die Druckschrift WO 01/44822 A1 zeigt einen kapazitiven Beschleunigungssensor mit unterschiedlichen Opferschichtdicken unter festen und beweglichen Elektroden, sowie ein zugehöriges Herstellungsverfahren.

### VORTEILE DER ERFINDUNG

Die Erfindung geht aus von einem Verfahren zur Herstellung eines gemäß Anspruch 1 mikromechanischen Bauelements

Vorteilhaft lässt sich so ein Oberflächenprofil an der Oberseite der zweiten Zwischenschicht und folglich ein dazu komplementäres Oberflächenprofil an der Unterseite der zweiten Schicht schaffen, dass nicht durch das Oberflächenprofil der strukturierten ersten Schicht bestimmt ist.

Der erfindungsgemäße Prozessablauf kann sowohl für Beschleunigungs- und Drehratensensoren, als auch für beliebige Bauelemente mit beweglichen mikromechanischen Strukturen in Silizium-Oberflächenmikromechanik verwendet werden.

Eine vorteilhafte Ausgestaltung des erfindungsgemäßen Verfahrens sieht vor, dass das Oberflächenprofil der zweiten Zwischenschicht im wesentlichen eingeebnet wird. Vorteilhaft entsteht so eine ebene Unterseite der nachfolgend erzeugten zweiten Schicht, die im Bereich der später daraus strukturierten beweglichen Struktur als Anschlagfläche besonders gut geeignet ist.

Eine weitere vorteilhafte Ausgestaltung sieht vor. dass zunächst eine erste Lage der zweiten Zwischenschicht aufgebracht, und nach dem Verändern des Oberflächenprofils der erste Lage eine zweite Lage der zweiten Zwischenschicht darauf abgeschieden wird. Vorteilhaft kann hierbei zunächst das Oberflächenprofil einer dünnen zweiten Zwischenschicht, nämlich der ersten Lage modelliert werden. Vorteilhaft kann hierzu beispielsweise die darunterliegende erste Schicht als Ätzstoppschicht genutzt werden. Vorteilhaft kann anschließend eine zweite Lage der zweiten Zwischenschicht darauf im Wesentlichen konform abgeschieden werden, derart, dass das geschaffene Oberflächenprofil erhalten bleibt.

Weitere vorteilhafte Ausgestaltungen sind den Unteransprüchen zu entnehmen.

### ZEICHNUNG

Ausführungsbeispiele der Erfindung sind in der Zeichnung dargestellt und in der nachfolgenden Beschreibung näher erläutert.

In den Figuren 1 bis 4 wird ein Verfahren zur Herstellung von oberflächenmikromechanischen Bauelementen nach Stand der Technik beschrieben.

Die Fig. 5 und 6 zeigen ein erstes Ausführungsbeispiel eines erfindungsgemäßen Herstellungs verfahren.

Die Fig. 7 und 8 zeigen ein zweites Ausführungsbeispiel eines erfindungsgemäßen Herstellungs verfahren.

Fig. 9 zeigt eine schematische Darstellung des erfindungsgemäßen Herstellungs verfahrens.

### BESCHREIBUNG VON AUSFÜHRUNGSBEISPIELEN

Anhand der im Folgenden beschriebenen Ausführungsformen soll die Erfindung detailliert dargestellt werden.

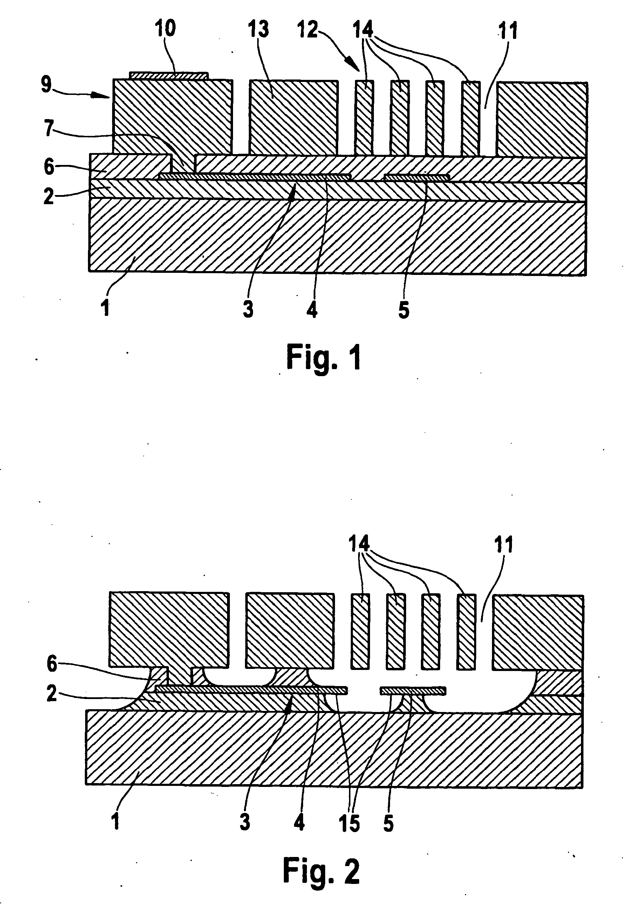

In den Figuren 1 bis 4 wird ein Verfahren zur Herstellung von oberflächen-mikromechanischen Bauelementen nach Stand der Technik beschrieben. Das Herstellungsverfahren und ein solchermaßen hergestellter mikromechanischer Sensor sind aus der deutschen Offenlegungsschrift DE 19537814 A1 bekannt. Diese Schrift wird ausdrücklich in diese Beschreibung als Teil der Offenbarung aufgenommen.

Fig: 1 zeigt den nachfolgend beschriebenen Schichtaufbau vor dem Entfernen einer Opferschicht. Bei diesem Schichtsystem wird zunächst auf einem Siliziumsubstrat 1 eine erste Isolationsschicht 2 aus einem Oxid abgeschieden. Auf dieser ersten Isolationsschicht 2 wird eine dünne dotierte Siliziumschicht 3 abgeschieden, welche eine leitfähige Schicht darstellt. Diese wird über einen fotolithografischen Prozess strukturiert. Die dotierte Siliziumschicht 3 ist so in einzelne gegeneinander isolierte Bereiche 4, 5 unterteilt, die als Leiterbahnen oder Flächenelektroden dienen können. Über die bisher aufgebrachten Schichten wird eine zweite Isolationsschicht 6 aus einem Oxid 6 abgeschieden. In einem fotolithografischen Prozess erfolgt eine Strukturierung der zweiten Isolationsschicht 6. Dadurch werden Kontaktdurchführungen 7, sogenannte Kontaktvias, in die zweite Isolationsschicht 6 eingebracht, durch welche die darunter liegende dotierte Siliziumschicht 3 kontaktiert werden kann. Im weiteren erfolgt die Abscheidung, Planarisierung und Dotierung einer dicken Siliziumschicht 9. Auf diese dicke Siliziumschicht 9 wird dann eine strukturierte Metallschicht 10 aufgebracht. In einem weiteren fotolithografischen Prozess erfolgt die Strukturierung der dicken Siliziumschicht 9. Dazu wird auf der Oberseite der dicken Siliziumschicht 9 eine Fotomaske aufgebracht, die auch einen Schutz der strukturierten Metallschicht 10 in der nachfolgenden Ätzung bewirkt. Durch Öffnungen der Fotolackmaske hindurch erfolgt anschließend eine Plasmaätzung der dicken Siliziumschicht 9, wie in der deutschen Offenlegungsschrift DE 4241045 A1 beschrieben, wobei Gräben 11 mit hohem Aspektverhältnis eingebracht werden. Die Gräben 11 erstrecken sich von der Oberseite der dicken Siliziumschicht 9 bis zur zweiten Isolationsschicht 6. Die Siliziumschicht 9 wird so in einzelne Bereiche 12, 13 unterteilt, die gegeneinander isoliert sind, sofern sie nicht über die vergrabene Leitschicht, welche durch die dotierte Siliziumschicht 3 gebildet ist, miteinander verbunden sind.

Durch die Gräben 11 hindurch erfolgt dann das Entfernen der beiden aus Oxid bestehenden Isolationsschichten 2 und 6 im Bereich von beweglichen Strukturen 14. insbesondere frei beweglichen Strukturen, des mikromechanischen Bauelements. wie in Fig. 2 gezeigt ist. Durch das Entfernen der ersten Isolationsschicht 2 während des Opferschichtätzens werden auch die strukturierten Leiterbahnen 4 und 5 teilsweise unterätzt, wodurch unterätzte Abschnitte 15 entstehen.

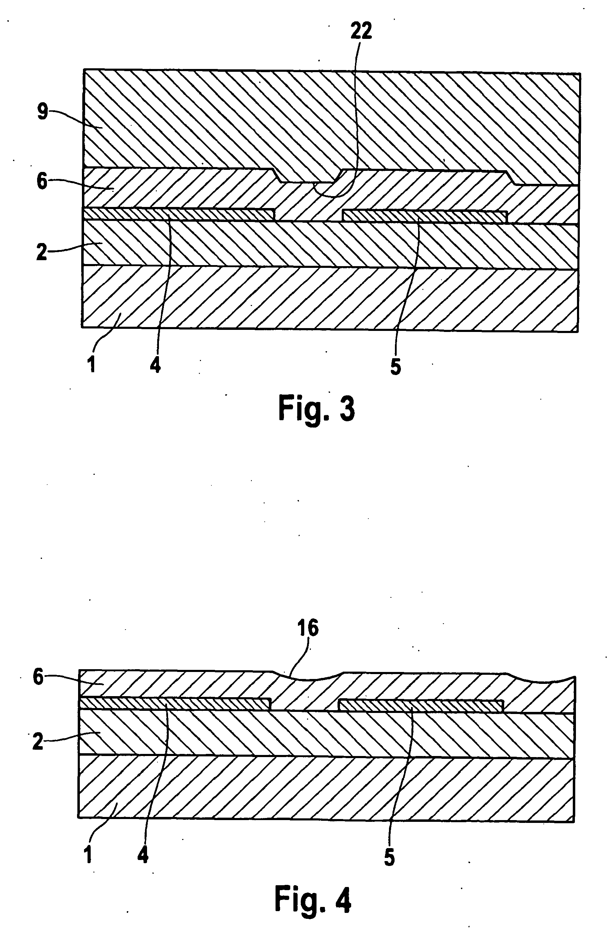

Bei einem schichtweisen Aufbau des Sensors wird das Oberflächenprofil der strukturierten Leiterbahnen 4 und 5 konform von der zweiten Isolationsschicht 6 und der Siliziumschicht 9 abgebildet, wie in Fig. 3 dargestellt ist. Somit wird auch die Form des Oberflächenprofils der dotierten Siliziumschicht 3 mit den strukturierten Bereichen 4 und 5 auf die Unterseite 22 der Siliziumschicht 9 übeilragen. In der Folge weist die Unterseite 22 stufenförmig Strukturen auf.

Bei dem hier beschriebenen Verfahren im Stand der Technik kann unter Umständen das Problem auftreten, dass beim mechanischen Kontakt der frei beweglichen Strukturen 14 mit den Leiterbahnen 4 und 5 unterätzte Abschnitte 15 dieser Leiterbahnen abbrechen und damit elektrisch leitfähige Siliziumpartikel erzeugen können. Solche Phänomene treten bei Beschleunigungen, wie zum Beispiel durch einen Fall des Sensorelements aus großer Höhe auf. Die Siliziumpartikel können zu einem elektrischen Nebenschluss führen und dadurch die elektrische und mechanische Funktionalität des mikromechanischen Bauelements beeinträchtigen. Bei dem mechanischen Anschlagen der frei beweglichen Strukturen 14 wirken die Stufen auf der Unterseite 22 der Siliziumschicht 9 verstärkend auf die Häufigkeit der Schädigung der Leiterbahnen 4, 5. Diese Stufen konzentrieren die Kraft beim Aufschlagen der beweglichen Struktur 14 auf einen kleinen Bereich am Rande der unterätzten Abschnitte 15, welche naturgemäß nur eine geringe mechanische Stabilität aufweisen.

Eine Beseitigung der Stufen an der Unterseite 22 der Siliziumschicht 9 durch ein chemisch mechanisches Polieren (CMP) der zweiten Isolationsschicht 6 vor dem Aufbringen der Siliziumschicht 9 kann unter Umständen nicht ausreichend sein. Das in der zweiten Isolationsschicht 6 abgebildete Oberflächenprofil der strukturierten Leiterbahnen 4 und 5 Die von den Leiterbahnen 4 und 5 erzeugten Stufen werden aufgrund der elastischen Eigenschaften des Poliertuchs nicht vollständig besengt sondern nur geglättet. Es entsteht ein Oberflächenprofil mit verringerter Profiltiefe 16, wie in Fig. 4 gezeigt ist.

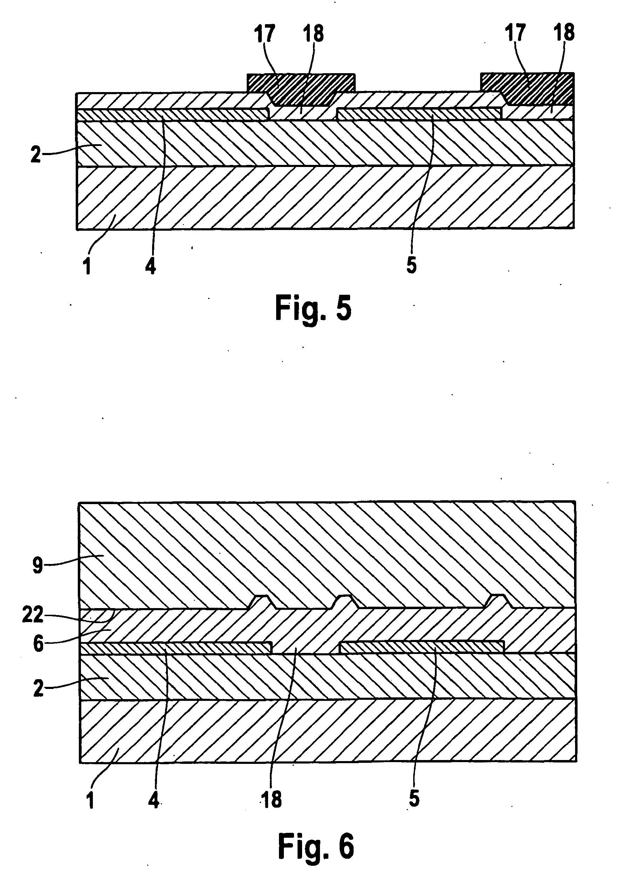

Die Fig. 5 und 6 zeigen ein erstes Ausführungsbeispiel eines Bauelements und seiner Herstellung. Nach dem Strukturieren der Siliziumleiterbahnen 4 und 5 wird eine dünne Oxidschicht 18, insbesondere aus Siliziumoxid bestehend, abgeschieden. Die Dicke dieser dünnen Oxidschicht 18 muss gleich der Schichtdicke der Siliziumleiterbahnen 4, 5 sein oder größer.

Gemäß Fig. 5 erfolgt über einen fotolithographischen Prozess mit einer Maske 17 und ein anschließendes geeignetes Ätzverfahren die Strukturierung der dünnen Oxidschicht 18. Dabei wird das Oxid über der Siliziumleiterbahn 4, 5 entfernt. Vorzugsweise wird das Oxid über der Siliziumleiterbahn 4, 5 bis auf einen schmalen Rand vollständig entfernt. Der Rand ist durch die Ausdehnung der Maske 17 über Randbereiche der Leiterbahnen 4, 5 bestimmt und dient dazu, eine Unterätzung der Leiterbahnen 4, 5 sicher zu vermeiden. Der Ätzschritt zum Strukturieren der dünnen Oxidschicht 18 kann sowohl durch ein isotropes als auch ein anisotropes Ätzverfahren aus der Flüssig- oder Gasphase erfolgen. Die Siliziumleiterbahnen 4, 5 wirken beim Ätzen der dünnen Oxidschicht 18 als Ätzstopp, so dass keine zeitkritische Steuerung des Ätzvorgangs notwendig ist. Über die so strukturierte dünne Oxidschicht 18 wird nachfolgend die zweite Isolationsschicht 6 abgeschieden und es werden die Kontaktvias 7 eingebracht. Im weiteren Prozessablauf wird die dicke Siliziumschicht 9 abgeschieden.

Der schematische Schichtaufbau nach dem Aufbringen der dicken Siliziumschicht 9 ist in Fig. 6 dargestellt. Durch den Einsatz der dünnen Oxidschicht 18 als Zwischenschicht wird die Stufe in der Unterseite 22 der Siliziumschicht 9, insbesondere im Bereich der beweglichen Struktur 14, vermieden. Als Folge davon, stehen keine Erhebungen mehr an der Unterseite 22 der Siliziumschicht 9 über. Beim einem möglichen Anschlagen der beweglichen Strukturen 14 infolge von Beschleunigungen senkrecht zur Substratebene wirkt somit der gesamte untere Bereich der Siliziumschicht 9 als ein mechanisch wirksamer Anschlag und die nicht unterätzten Bereiche der Leiterbahnen 4 und 5 als zweiter stabiler Anschlag, nämlich als Gegenstück des ersten Anschlags. Die nicht unterätzen Bereiche der Leiterbahnen 4, 5 weisen eine deutlich höhere mechanische Stabilität auf als die unterätzten Abschnitte 15 im Stand der Technik. Beim Autsenfagen der beweglichen Strukturen 14 auf die Siliziumbahnen 4, 5 können somit bei der erfindungsgemäßen Ausführung des mikromechanischen Bauelements keine Teile der Leiterbahnen 4, 5 abbrechen.

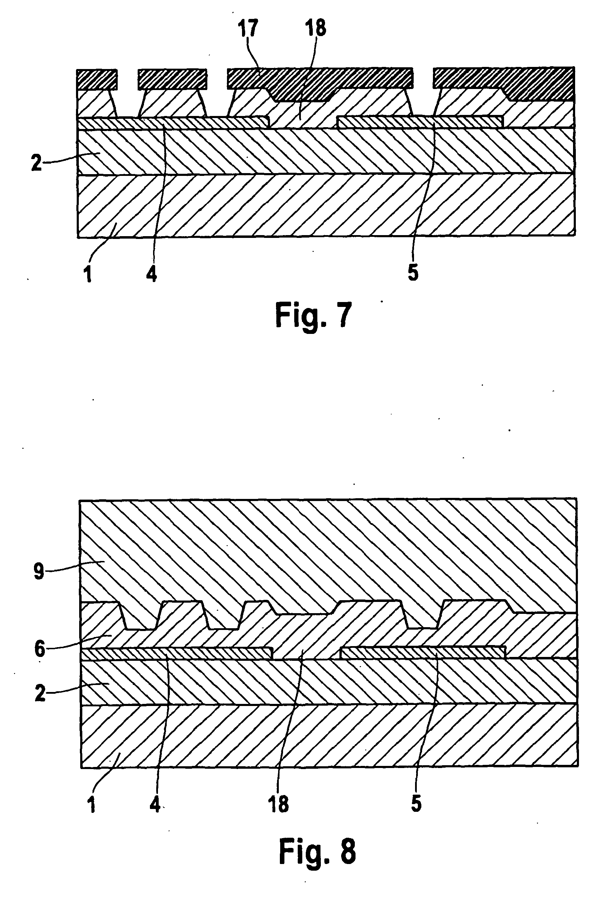

Die Fig. 7 und 8 zeigen ein zweites Ausführungsbeispiel eines mikromechanischen Bauelements und seiner Herstellung.

In einer zweiten Ausführungsvariante wird, wie im beschriebenen ersten erfindungsgemäßen Verfahren, über die bereits strukturierten Siliziumleiterbahnen 4 und 5 eine dünne Oxidschicht 18 abgeschieden und über einen fotolithographischen Prozess mittels einer Maske 17 strukturiert. Dies ist in Fig. 7 veranschaulicht. Die Schichtdicke der dünnen Oxidschicht 18 ist nun aber größer, vorzugsweise mindestens doppelt so hoch wie die Dicke der Siliziumschicht 3. Die dünne Oxidschicht 18 wird hier nur lokal über den Leiterbahnen 4, 5 geöffnet. Dies geschieht mittels eines üblichen Ätzprozesses. Nachfolgend wird die zweite Isolationsschicht 6 abgeschieden und die Kontaktvias 7 strukturiert. Im weiteren Prozessablauf wird die dicke Siliziumschicht 9 abgeschieden.

Der schematische Schichtaufbau nach dem Aufbringen, insbesondere Aufwachsen, der Siliziumschicht 9 ist in Fig. 8 dargestellt. Der Vorteil dieses Verfahrens ist, dass sich noppenförmige Anschläge an der Unterseite der dicken Siliziumschicht erzeugen lassen. Diese Anschläge können zur Überlastbegrenzung in einer Richtung senkrecht zur Substratoberfläche, der z-Richtung genutzt werden oder als Abstandshalter wirken, um z.B. das Ankleben der beweglichen Strukturen 14 aufgrund von Kapillarkräften beim nasschemischen Ätzen der Opferschichten, nämlich der Isolationsschichten 6 und 2 zu verhindern.

Allgemein lässt sich die Erfindung für alle ein oberflächenmikromechanisches Bauelement mit wenigstens einer beweglichen Struktur 14 einsetzen, das unter anderem durch Opferschichtätzen hergestellt wird, wenn dieses Bauelement ein Substrat 1, darüber eine erste Zwischenschicht 2, darauf eine erste Schicht 3 welche strukturiert ist, darauf eine zweite Zwischenschicht 6 und darauf eine zweite Schicht 9 aufweist, aus der die bewegliche Struktur 14 herausstrukturiert ist. Erfindungsgemäß weist das Bauelement dabei eine bewegliche mikromechanische Struktur 14 mit wenigstens einer Anschlagfläche an einer Unterseite auf. Die Anschlagfläche ist durch eine Ausienkung der beweglichen mikromechanischen Struktur 14 an einen Bereich der ersten Schicht 3 anlegbar, welcher durch die erste Zwischenschicht 2 gestützt ist: Die Bezugszeichen sind von den vorher beschriebenen Ausführungsbeispielen auf dieses verallgemeinerte Ausführungsbeispiel übertragen.

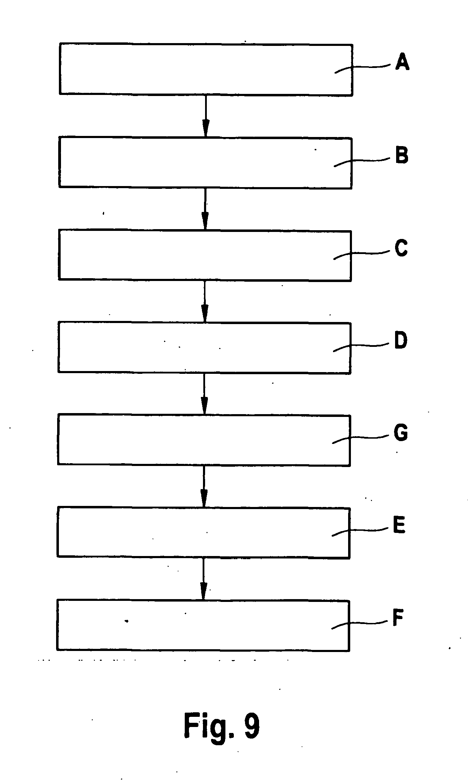

Fig. 9 zeigt eine schematische Darstellung des erfindungsgemäßen Herstellungsverfahrens. Dargestellt ist ein Verfahren zur Herstellung eines mikromechanischen Bauelements mit den Herstellungsschritten:
(A) Bereitstellen eines Substrats 1,
(B) Aufbringen einer ersten Zwischenschicht 2,
(C) Aufbringen und Strukturieren einer ersten Schicht 3,
(D) Aufbringen einer zweiten Zwischenschicht 18, 6,
(E) Aufbringen und Strukturieren einer zweiten Schicht 9,
(F) Freilegen wenigstens eines Teils der zweiten Schicht 9 zur Ausbildung einer beweglichen Struktur 14 durch Ätzen von Teilen der ersten Zwischenschicht 2 und der zweiten Zwischenschicht 18, 6 in einem Opferbereich,
wobei nach dem Schritt (D) und vor dem Schritt (E) in einem Schritt (G) ein Oberflächenprofil der zweiten Zwischenschicht 18, 6 durch Aufbringen einer Maske und anschließendes Ätzen der zweiten Zwischenschicht 6 verändert wird, und
in das Oberflächenprofil der zweiten wird Zwischenschicht 6 wenigstens eine Negativform für einen Anschlag in der zweiten Schicht 9 hineinstrukturiert.

In einer weiteren Ausgestaltung wird im Schritt (D) zunächst eine erste Lage der zweiten Zwischenschicht 18 aufgebracht und im Schritt G nach dem Verändern des Oberflächenprofils der erste Lage der zweiten Zwischenschicht 18 eine zweite Lage der zweiten Zwischenschicht 6 darauf abgeschieden.

## Patentansprüche

1. Verfahren zur Herstellung eines mikromechanischen Bauelements mit den Herstellungsschritten:
(A) Bereitstellen eines Substrats (1),
(B) Aufbringen einer ersten Zwischenschicht (2),
(C) Aufbringen und Strukturieren einer ersten Schicht (3),
(D) Aufbringen einer zweiten Zwischenschicht (18, 6),
(E) Aufbringen und Strukturieren einer zweiten Schicht (9),
(F) Freilegen wenigstens eines Teils der zweiten Schicht (9) zur Ausbildung einer beweglichen Struktur (14) durch Ätzen von Teilen der ersten Zwischenschicht (2) und der zweiten Zwischenschicht (6) in einem Opferbereich,
**dadurch gekennzeichnet, dass**
nach dem Schritt (D) und vor dem Schritt (E) in einem Schritt (G) ein Oberflächenprofil der zweiten Zwischenschicht (18) durch Aufbringen einer Maske (17) und anschließendes Ätzen der zweiten Zwischenschicht (18, 6) verändert wird, wobei in das Oberflächenprofil der zweiten Zwischenschicht (18, 6) wenigstens eine Negativform für einen Anschlag in der zweiten Schicht (9) hineinstrukturiert wird.

2. Verfahren zur Herstellung eines oberflächenmikromechanischen Bauelements nach Anspruch 1, **dadurch gekennzeichnet, dass** das Oberflächenprofil der zweiten Zwischenschicht (18, 6) im Wesentlichen eingeebnet wird.

3. Verfahren zur Herstellung eines oberflächenmikromechanischen Bauelements nach Anspruch 1, **dadurch gekennzeichnet, dass** im Schritt (D) zunächst eine erste Lage der zweiten Zwischenschicht (18) aufgebracht wird und nach dem Verändern des Oberflächenprofils der erste Lage der zweiten Zwischenschicht (18) eine zweite Lage der zweiten Zwischenschicht (6) darauf abgeschieden wird.

## Claims

1. Method for producing a micromechanical component comprising the following production steps:
(A) providing a substrate (1),
(B) applying a first intermediate layer (2),
(C) applying and structuring a first layer (3),
(D) applying a second intermediate layer (18, 6),
(E) applying and structuring a second layer (9),
(F) uncovering at least one part of the second layer (9) for the purpose of forming a movable structure (14) by etching parts of the first intermediate layer (2) and the second intermediate layer (6) in a sacrificial region,
**characterized in that**
after step (D) and before step (E), in a step (G), a surface profile of the second intermediate layer (18) is altered by applying a mask (17) and subsequently etching the second intermediate layer (18, 6), at least one negative form for a stop in the second layer (9) being structured into the surface profile of the second intermediate layer (18, 6).

2. Method for producing a surface-micromechanical component according to Claim 1, **characterized in that** the surface profile of the second intermediate layer (18, 6) is substantially levelled.

3. Method for producing a surface-micromechanical component according to Claim 1, **characterized in that**, in step (D), firstly a first ply of the second intermediate layer (18) is applied and, after the alteration of the surface profile of the first ply of the second intermediate layer (18), a second ply of the second intermediate layer (6) is deposited thereon.

## Revendications

1. Procédé de fabrication d'un composant micromécanique comprenant les étapes de fabrication suivantes :
(A) fourniture d'un substrat (1),
(B) application d'une première couche intermédiaire (2),
(C) application et structuration d'une première couche (3),
(D) application d'une deuxième couche intermédiaire (18, 6),
(E) application et structuration d'une deuxième couche (9),
(F) dénudage d'au moins une partie de la deuxième couche (9) pour créer une structure mobile (14) par attaque chimique de parties de la première couche intermédiaire (2) et de la deuxième couche intermédiaire (6) dans une zone sacrificielle,
**caractérisé en ce**
**qu'**après l'étape (D) et avant l'étape (E), dans une étape (G), un profil de surface de la deuxième couche intermédiaire (18) est modifié par l'application d'un masque (17) et attaque chimique subséquente de la deuxième couche intermédiaire (18, 6), au moins un moule négatif pour une butée dans la deuxième couche (9) étant incorporé dans la structuration du profil de surface de la deuxième couche intermédiaire (18, 6).

2. Procédé de fabrication d'un composant micromécanique de surface selon la revendication 1, **caractérisé en ce que** le profil de surface de la deuxième couche intermédiaire (18, 6) est essentiellement aplani.

3. Procédé de fabrication d'un composant micromécanique de surface selon la revendication 1, **caractérisé en ce que** dans l'étape (D), une première strate de la deuxième couche intermédiaire (18) est d'abord appliquée, et après la modification du profil de surface de la première strate de la deuxième couche intermédiaire (18), une deuxième strate de la deuxième couche intermédiaire (6) est déposée pardessus.
